# EUROPEAN PATENT APPLICATION

(11) **EP 4 550 944 A1**
(43) Date of publication of application: **07.05.2025**
(21) Application number: 23215125.8
(22) Date of filing: 08.12.2023
(51) Int. Cl.: H05K 1/02, H05K 1/14, H05K 3/28, H05K 3/34, G06F 1/18, H01L 25/16, H01L 25/00, H01L 23/31, H05K 1/18

(54) **MICRO ALL-IN-ONE COMPUTER CHIP SYSTEM BASED ON OSM-L STANDARD**

(30) Priority: 30.10.2023 TW 112141610
(71) Applicant: Mitwell, Inc., 236042 New Taipei City (TW)
(72) Inventor: YU, Yu-Hsiang, 236042 New Taipei City (TW); CHANG, Yu-Cheng, 236042 New Taipei City (TW)
(74) Representative: Zeitler Volpert Kandlbinder Patentanwälte Partnerschaft mbB

(57) **Abstract**

A micro all-in-one computer chip system (1) based on OSM-L standard includes: a 45mm*45mm system circuit carrier board (10) with a top layer (11) and a bottom layer (12), the top layer (11) having an integrated circuit (111) with a highly integrated circuit design, and the bottom layer (12) having an OSM-L interface (121) defined by SGeT; a system on a chip (20), a memory system (30) and a power circuit module (40) which are electrically connected and installed to the top layer (11) of the carrier board (10); and an enclosure cover (50), being hollow at the bottom of the enclosure cover (50) and having a containing space (53) provided for installing the system circuit carrier board (10), and a thermal paste being coated and filled into the accommodation gap (54) of the enclosure cover (50). In this way, it becomes a micro all-in-one computer chip system (1) with complete functions, and enables the micro all-in-one computer chip system (1) to be widely used in industrial computer, Internet of Things, edge computing, artificial intelligence, and various applications as a chip/IC, and becomes the standard for the development and operation among industries.

## Description

### FIELD OF THE INVENTION

The present invention relates to a micro all-in-one computer chip assembly, and more particularly to a micro all-in-one computer chip system based on OSM-L standard which integrates three major computer components: a processor, a memory, and a power supply into a microcomputer chip system.

### BACKGROUND OF THE INVENTION

### 1. Description of the Related Art

Computer is a common device that modern people used at work or in daily life, and it includes personal computer, industrial computer or other special-purpose computer, etc., and hardware devices of a computer are generally divided into four major units, such as a processor (CPU), a memory; an input/output interface (I/O port) and a power supply (PSU). The evolution of computer is mainly based on the central processing unit (CPU), which determines the computing power of the computer, all software and I/O interfaces are based on its ability to design various applications and devices, so that computer motherboard manufacturers carry out the wiring design and the integration of memory and power supply based on CPU planning. It can be said that CPU is the mainstream of computer chips that determines the development of the information and communication technology (ICT) industry.

As for the integration of CPU, memory and power supply, these components usually come with a set. In other words, these components are usually arranged and wired in a limited space, while maintaining the equilibrium of the electromagnetic effect to avoid mutual interference. The I/O devices often vary significantly with the customers' applications, the cable devices rely on connectors of different sizes for transmission, and the wireless devices rely on the chips of different frequency bands to transmit information. However, the CPU, memory and power supply/power supply circuit in the current computer industry have not been integrated very well, and the computer microchip cannot be made into a universal industrial standard, so that the design of computer systems is still complex, and thus is not conducive to the reduction of development time and the improvement of system stability. Obviously, it is not an ideal design for computer systems.

In addition, system module standards such as SMARC, Qseven, COMe, PC/104, etc. are widely adopted in the area of industrial computers to realize the high integration and flexibility of embedded computing. In order to further promote the development of this field, the Standardization Group for Embedded Technologies (SGeT) launched the open standard module (OSM) in 2020, of which the OSM-L standard adopts the stamp-like size of 45*45mm, which is applied in the embedded system of the industrial computer and makes the OSM-L module with its performance, cost and space efficiency the first choice of many manufacturers in the fields of Internet of Things and edge computing. Therefore, how to effectively use this OSM-L module structure together with the main assembly units of the computer device to form an overall computer chip integrated design and promote and apply this structure in the industrial computer system should be the major direction for the industry to develop and breakthrough.

In view of the deficiencies of the design on the related-art computer system structure and the fact that the related-art structural design is not ideal, the inventor of the present disclosure has begun research for a feasible solution and provided a micro all-in-one computer chip system based on OSM-L standard with a microcomputer chip that standardizes and optimizes its related functions, to serve the public and promote the development of this industry. The present disclosure has been created after a long time of conceptualization.

### 2. Summary of the Invention

Therefore, it is a primary objective of the present disclosure to provide a micro all-in-one computer chip system based on OSM-L standard with a highly integrated circuit design, where a CPU, a memory and a power supply circuit are installed in the space of a microcomputer chip with a size of 45mm (length) *45mm (width), so it becomes a microcomputer chip with complete functions provided to assemble an All-in-One Computer (AIOC), and make the microcomputer chip to be a universal industrial standard. The present disclosure simplifies the complexity of computer design in the future and has the advantages of reducing development time and improving system stability.

Another objective of the present disclosure is to provide a micro all-in-one computer chip system based on OSM-L standard, which can provide a specific interface recognized by the industry to integrate various I/O devices, so as to achieve the effect of communicating with the input interface of motherboards of various sizes and shapes and the purpose of transmission and control with excellent efficiency.

A further objective of the present disclosure is to provide a micro all-in-one computer chip system based on OSM-L standard, which can use the thermal conductivity and package heat dissipation design to effectively dissipate the heat generated by the 3-in-1 highly integrated circuits of various I/O devices and greatly lower the temperature.

Another objective of the present disclosure is to provide a micro all-in-one computer chip system based on OSM-L standard, which can use the OSM-L standard to provide a vibration-resisting PCB solderable module with a compact form having the maximum pin-to-area ratio, while considering the technological scalability and meeting the integration requirements for high performance and miniaturization. The present disclosure can be widely applied in the areas of Internet of Things, edge computing, artificial intelligence and computing centers of various applications.

To achieve the aforementioned and other objectives, the present invention adopts a technical measure, including: a system circuit carrier board, which is a 45mm (length) *45mm (width) carrier board, having a top layer of the carrier board and a bottom layer of the carrier board, the top layer of the carrier board having an integrated circuit with a highly integrated circuit design, and the bottom layer of the carrier board having an OSM-L interface defined by SGeT; a system on a chip (SoC), electrically connected and installed to the top layer of the carrier board; a memory system, electrically connected and installed to the top layer of the carrier board; a power circuit module, electrically connected and installed to the top layer of the carrier board; an enclosure cover, including a top cover and a surrounding side cover, the bottom of the enclosure cover being hollow, and the enclosure cover having a containing space for installing the system circuit carrier board, and downwardly exposing the OSM-L interface, an accommodation gap being formed between the enclosure cover and the system circuit carrier board, the system on a chip (SoC), the memory system and the power circuit module, and coated and filled with a thermal paste.

In this embodiment, the OSM-L interface at the bottom layer of the carrier board defines 662 pins/nodes used as an external connection interface.

In this embodiment, the integrated circuit comprises: a first module area for installing the system on a chip (SoC), a second module area for installing the memory system, and a third module area for installing the power circuit module.

In this embodiment, the OSM-L interface uses a symmetric LGA package, and the contact technology adopts LGA or BGA.

In this embodiment, the enclosure cover has a longitudinal/transverse section designed as a heat sink with a U-shaped cross section.

In this embodiment, the system circuit carrier board, the system on a chip (SoC), the memory system, the power circuit module and the enclosure cover are combined to form a micro all-in-one computer chip, and the plurality of micro all-in-one computer chips is installed on a system motherboard of an industrial computer.

In this embodiment, the power circuit module comprises a power supply and an electronic control unit of the power supply.

In this embodiment, the memory system comprises a memory substrate and a memory assembly which are electrically coupled to the memory system, and the memory assembly comprises at least one main memory and another optional storage memory.

The technical characteristics and effects of the present disclosure will become clearer in light of the following detailed description of an illustrative embodiment of this invention described in connection with the drawings.

### BRIEF DESCRIPTION OF THE DRAWINGS

FIG. 1 is an exploded view of the present disclosure;
FIG. 2 is a top view of an assembly of the present disclosure;
FIG. 3 is a cross-sectional view of an assembly of the present disclosure;
FIG. 4 is a schematic view of an application of the present disclosure; and
FIG. 5 is a schematic logic block diagram of the present disclosure.

### DESCRIPTION OF THE PREFERRED EMBODIMENTS

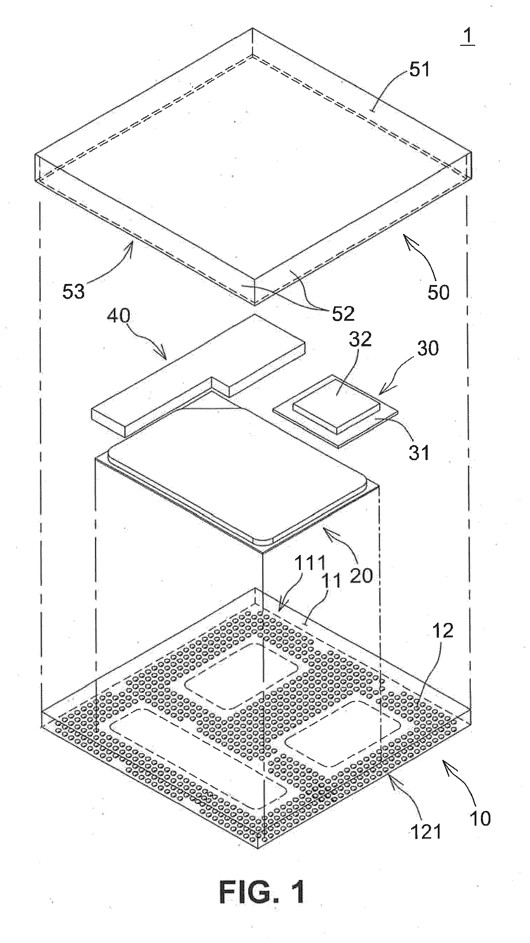

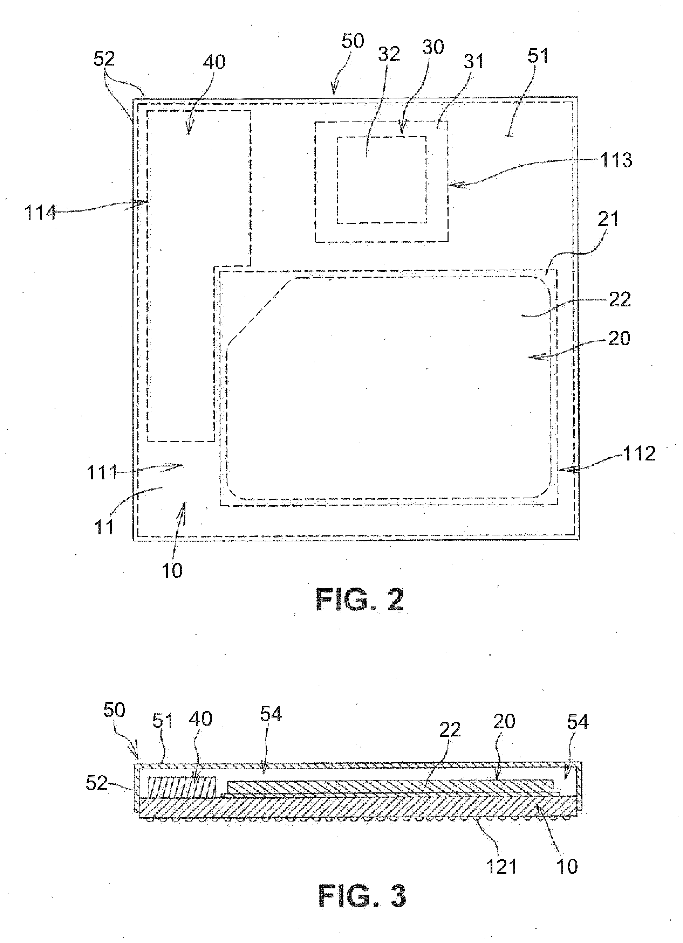

With reference to FIGS. 1, 2 and 3 for a micro all-in-one computer chip system based on OSM-L standard in accordance with an embodiment of the present disclosure, the drawings disclosed herein are to be considered illustrative rather than restrictive. The micro all-in-one computer chip system 1 includes a system circuit carrier board 10, a system on a chip (SoC) 20, a memory system 30, a power circuit module 40 and an enclosure cover 50, wherein the system circuit carrier board 10 is a 45mm (length) * 45mm (width) carrier board, the system circuit carrier board 10 has a top layer 11 of the carrier board 10 and a bottom layer 12 of the carrier board 10, the top layer 11 of the carrier board 10 has an integrated circuit 111 with a highly integrated circuit design, the integrated circuit 111 at least includes a first module area 112, a second module area 113 and a third module area 114 (as shown in FIG. 2) for installing the system on a chip (SoC) 20, the memory system 30 and the power circuit module 40 respectively. The bottom layer 12 of the carrier board 10 has an OSM-L interface 121 of an open standard module (OSM) defined by SGeT, the OSM-L interface at the bottom layer 12 of the carrier board 10 provides an embedded computing application and defines 662 pins/nodes (pinouts) as an external connection interface. In addition, the OSM-L interface 121 adopts a symmetric land grid array/planar grid array (LGA), the contact technology adopts the LGA or a ball grid array (BGA). The OSM-L interface 121 can be manufactured by machines during the soldering, assembling and testing periods and adopts the pre-tinned LGA for direct soldering without connector. In the meantime, the OSM-L interface 121 is a pre-defined software/hardware interface.

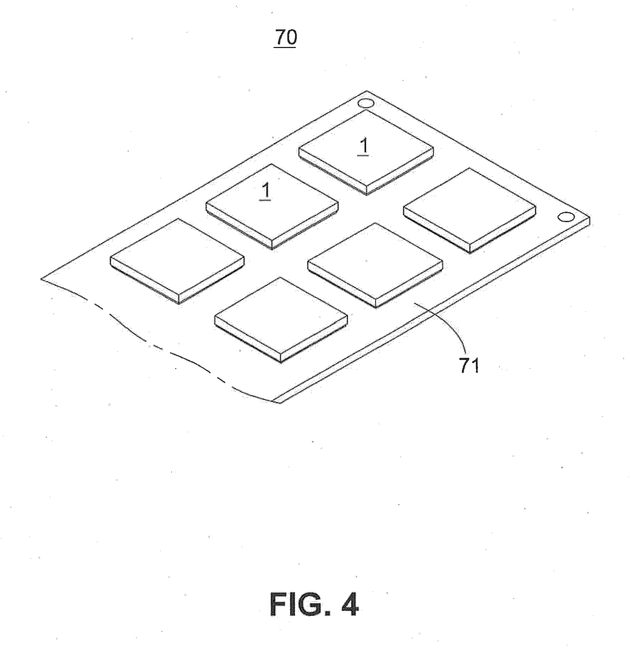

In this way, the space of the system circuit carrier board 10, the integrated circuit 111 and the OSM-L interface 121 are provided to communicate with the input interface of a system motherboard 71 of various sizes and shapes (see FIG. 4) to achieve the purposes of transmission and control and can become a universal industrial standard, which simplifies the complexity of computer design in the future and has the advantages of reducing development time and improving system stability.

The system on a chip (SoC) 20 includes a CPU substrate 21 and a CPU 22 which are electrically connected to the system on a chip (SoC) 20, and the system on a chip (SoC) 20 is installed in the first module area 112 and electrically connected to the integrated circuit 111. The memory system 30 includes a memory substrate 31 and a memory assembly 32 which are electrically connected to the memory system 30, and the memory assembly 32 includes at least one main memory and other optional storage memories. The memory system 30 is installed in the second module area 113 and electrically connected to the integrated circuit 111. The power circuit module 40 is installed in the second module area 113, and the power circuit module 40 includes a power supply and its electronic control unit, and is electrically connected to the integrated circuit 111.

The enclosure cover 50 includes a top cover 51 and a surrounding side cover 52, such that the longitudinal/transverse section of the enclosure cover 50 has the design of a heat sink with a U-shaped cross section, the bottom of the enclosure cover 50 is hollow, and the enclosure cover 50 has a containing space 53 for installing the system circuit carrier board 10 after the system on a chip (SoC) 20, the memory system 30, and the power circuit module 40 are assembled, and downwardly exposing the OSM-L interface 121 (the bottom layer 12) of the system circuit carrier board 10, and there is an accommodation gap 54 between the enclosure cover 50 and the system circuit carrier board 10, the system on a chip (SoC) 20, the memory system 30, and the power circuit module 40. The accommodation gap 54 is provided for coating and filling a thermal paste (not shown in the figure), the thermal paste is used for the thermal conduction between the system circuit carrier board 10, the system on a chip (SoC) 20, the memory system 30, the power circuit module 40 and the enclosure cover 50 to equalize the heat generated by all modules, assemblies and components, so that the heat generated by the 3-in-1 integrated circuit 111 with a highly integrated design (including the system on a chip (SoC) 20, the memory system 30, and the power circuit module 40) can be greatly reduced by the thermal paste and the design of the enclosure cover 50 and its heat sink.

With reference to FIG. 4 for the application of the micro all-in-one computer chip system based on OSM-L standard in accordance with an embodiment of the present disclosure, an industrial computer 70 includes a system motherboard 71 with an OSM-L interface of embedded computing, at least one or a plurality of micro all-in-one computer chips 1 is mounted on the system motherboard 71, so the industrial computer can be simply, quickly and efficiently assembled, and the industrial computer can be assembled by selecting different quantities of micro all-in-one computer chips 1, or it is convenient to add micro all-in-one computer chips 1 for expansion in the future and enhance the overall performance and function. In this way, the micro all-in-one computer chip 1 of the present disclosure can be used just like a chip (Chip /IC) and conveniently promoted and applied in industrial computer, Internet of Things, edge computing, artificial intelligence and the computing centers of various applications, and becomes a universal industrial standard.

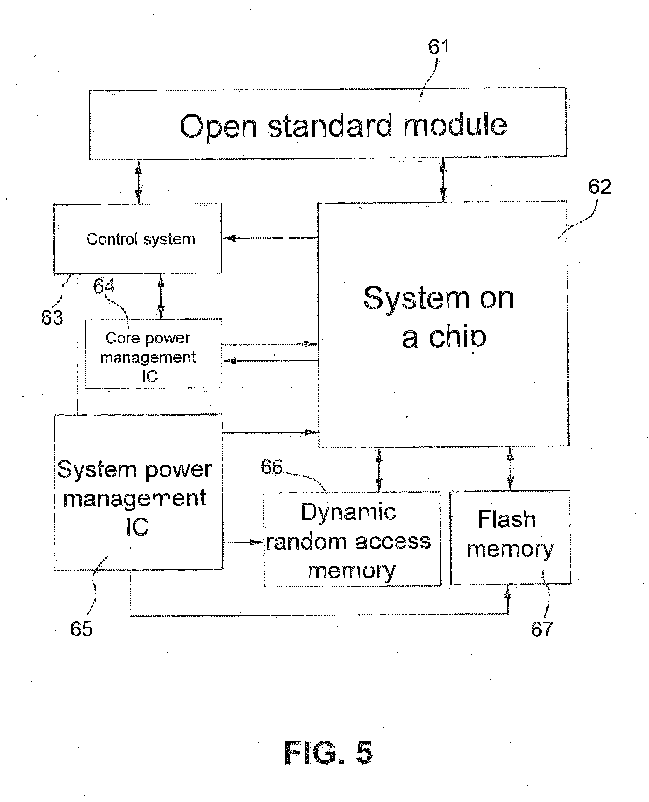

With reference to FIG. 5 for a schematic logic block diagram of an embodiment of the present disclosure, the open standard module pinout (OSM Pinout) 61 is electrically connected to a system on a chip (SoC) 62 and a control system (EC/MCU) 63, where the open standard module pinout 61 is the pin of the OSM-L interface 121, and the system on a chip (SoC) 62 can be the system on a chip (SoC) 20, and the control system 63 (EC/MCU) includes a combination of an electronic control unit (ECU) and a microcontroller (MCUr). In addition, a core power management IC (Core PMIC) 64 is electrically connected to the system on a chip (SoC) 62 and the control system (EC/MCU) 63. The system on a chip (SoC) 62 is electrically connected to a system power management IC 65 ( SYS PMIC), and the system power management IC 65( SYS PMIC) and the core power IC 64 (Core PMIC) are the component assemblies of the power circuit module 40, and the system power management IC 65 ( SYS PMIC) is electrically connected to a dynamic random access memory 66 (DRAM) and a flash memory 67 (Embedded Multi Media Card, eMMC), the dynamic random access memory 66 (DRAM) and flash memory 67 (eMMC) are component assemblies of the memory assembly 32 (memory system 30), so that related transmission and control operations of the circuit of this embodiment can be accomplished.

In the micro all-in-one computer chip system based on OSM-L standard of the present disclosure, the aforementioned assembly provides a highly integrated circuit design, and installs the CPU, memory and power supply circuit in a microcomputer chip with the dimensions of 45mm (length) * 45mm (width) to become a microcomputer chip with complete functions, and assembles it to an All-in-One Computer (AIOC), such that the microcomputer chip becomes a universal industrial standard to simplify the complexity of computer design in the future and enjoy the advantages of reducing development time and increasing system stability. At the same time, the present disclosure provides a specific interface recognized by the industry to integrate various I/O devices, so as to achieve the effect of communicating with the input interface of motherboards of various sizes and shapes and the purpose of transmission and control with excellent efficiency. In addition, the present disclosure can use the thermal conductivity and package heat dissipation design to effectively dissipate the heat generated by the 3-in-1 highly integrated circuits of various I/O devices and greatly lower the temperature, and the present disclosure can also use the OSM-L standard to provide a vibration-resisting PCB solderable module with a compact form having the maximum pin-to-area ratio, while considering the technological scalability and meeting the integration requirements for high performance and miniaturization.

While the technical characteristics and functions of the micro all-in-one computer chip system based on OSM-L standard of the present disclosure have been described by way of examples and in terms of preferred embodiments, it is to be understood that the invention is not limited thereto. To the contrary, it is intended to cover various modifications and similar arrangements and procedures, and the scope of the appended claims therefore should be accorded the broadest interpretation so as to encompass all such modifications and similar arrangements and procedures. It is noteworthy that the embodiments and figures disclosed herein are to be considered illustrative rather than restrictive.

## Claims

1. A micro all-in-one computer chip system based on OSM-L standard, comprising:
a system circuit carrier board (10), being a 45mm*45mm carrier board, having a top layer (11) and a bottom layer (12), the top layer (11) of the carrier board (10) having an integrated circuit (111) with a highly integrated circuit design, and the bottom layer (12) of the carrier board (10) having an OSM-L interface (121) defined by a SGeT;
a system on a chip (SoC) (20), electrically coupled and installed to the top layer (11) of the carrier board (10);
a memory system (30), electrically coupled and installed to the top layer (11) of the carrier board (10);
a power circuit module (40), electrically coupled and installed to the top layer (11) of the carrier board (10);
an enclosure cover (50), comprising a top cover (51) and a surrounding side cover (52), the bottom of the enclosure cover (50) being hollow to define a containing space (53) in the enclosure cover (50), the containing space (53) being provided for installing the system circuit carrier board (10) and downwardly exposing the OSM-L interface (121), the enclosure cover (50) having an accommodation gap (54) from the system circuit carrier board (10), the system on a chip (SoC) (20), the memory system (30) and the power circuit module (40), and coated and filled with a thermal paste.

2. The micro all-in-one computer chip system based on OSM-L standard according to claim 1, wherein the OSM-L interface (121) at the bottom layer (12) of the carrier board defines 662 pins/nodes used as an external connection interface.

3. The micro all-in-one computer chip system based on OSM-L standard according to claim 2, wherein the integrated circuit (111) comprises: a first module area (112) for installing the system on a chip (SoC) (20), a second module area (113) for installing the memory system (30), and a third module area (114) for installing the power circuit module (40).

4. The micro all-in-one computer chip system based on OSM-L standard according to claim 1, wherein the OSM-L interface (121) uses a symmetric LGA, and the contact technology adopts a LGA or a BGA.

5. The micro all-in-one computer chip system based on OSM-L standard according to claim 1, wherein the enclosure cover (50) has a longitudinal/transverse section designed as a heat sink with a U-shaped cross section.

6. The micro all-in-one computer chip system based on OSM-L standard according to claim 1, wherein the system circuit carrier board (10), the system on a chip (SoC) 20, the memory system (30), the power circuit module (40) and the enclosure cover (50) are combined to form a micro all-in-one computer chip (1), and the plurality of micro all-in-one computer chips (1) is installed on a system motherboard of an industrial computer.

7. The micro all-in-one computer chip system based on OSM-L standard according to claim 1, wherein the power circuit module (40) comprises a power supply and an electronic control unit thereof.

8. The micro all-in-one computer chip system based on OSM-L standard according to claim 1, wherein the memory system (30) comprises a memory substrate (31) and a memory assembly (32) which are electrically coupled to the memory system (30), and the memory assembly (32) comprises at least one main memory and another optional storage memory.
